(19) Europäisches Patentamt
European Patent Office
Office européen des brevets

(11) EP 1 231 252 A2

(12) **EUROPEAN PATENT APPLICATION**

(43) Date of publication:
**14.08.2002 Bulletin 2002/33**

(51) Int Cl.[7]: **C09K 11/06**, H05B 33/14, H01L 51/20

(21) Application number: **02250887.3**

(22) Date of filing: **08.02.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **08.02.2001 JP 2001032835**

(71) Applicants:
- **Nippon Steel Chemical Co., Ltd.**
  **Tokyo 141-0031 (JP)**
- **Pioneer Corporation**
  **Tokyo 153-8654 (JP)**
- **Tohoku Pioneer Corporation**
  **Tendo-shi, Yamagata 994-8585 (JP)**

(72) Inventors:
- **Matsuo, Shinji, Nippon Steel Chem. Co., Ltd.**
  **Kitakyushu-shi, Fukuoka 804-8503 (JP)**
- **Ishii, Kazuo, Nippon Steel Chem. Co., Ltd.**
  **Kitakyushu-shi, Fukuoka 804-8503 (JP)**
- **Miyazaki, Hiroshi, Nippon Steel Chem. Co., Ltd.**
  **Kitakyushu-shi, Fukuoka 804-8503 (JP)**
- **Yuki, Toshinao, Tohoku Pioneer Corporation**
  **Yamagata 992-1128 (JP)**
- **Nakada, Hitoshi, Tohoku Pioneer Corporation**
  **Yamagata 992-1128 (JP)**
- **Murayama, Ryuji, Tohoku Pioneer Corporation**
  **Yamagata 992-1128 (JP)**
- **Sawada, Yasuhiko, Tohoku Pioneer Corporation**
  **Yamagata 992-1128 (JP)**
- **Naijo, Tsuyoshi, Tohoku Pioneer Corporation**
  **Yamagata 992-1128 (JP)**
- **Fukuda, Yoshinori, Tohoku Pioneer Corporation**
  **Yamagata 992-1128 (JP)**

(74) Representative: **Towler, Philip Dean**
**Frank B. Dehn & Co.,**
**European Patent Attorneys,**
**179 Queen Victoria Street**
**London EC4V 4EL (GB)**

(54) **Organic electroluminescent material and device made therefrom**

(57) This invention relates to organic electroluminescent elemental devices (organic EL devices) of excellent durability and to organic EL materials useful for such organic EL devices. The organic EL material of this invention comprises a tertiary amine containing 2 to 4 nitrogen atoms each forming a triarylamine wherein the organic electroluminescent material comprises 1 wt.% or less of impurity compounds (A) possessing one less nitrogen atom forming a triarylamine group than said tertiary aryl amine compound and/or 2 wt.% or less of impurity compounds (B) possessing one more nitrogen atom forming a diarylamino group than said tertiary aryl amine compound. The organic electrominescent material can be used in an organic EL device. Some of such tertiary aryl amines are selected from compounds represented by
$(Ar_1Ar_2\ N-)_2-Ar_3$, $(Ar_1Ar_2N-\ Ar_3-)_3-N$, $(Ar_1Ar_2N-Ar_3-)_2-N-Ar_4$ and $(Ar_1Ar_2\ N-)_4-Ar_5$
(wherein $Ar_1$, $Ar_2$ and $Ar_4$ are independently monovalent aryl groups, $Ar_3$ is independently a divalent aryl group and $Ar_5$ is a tetravalent aryl group). The organic EL materials of this invention are used, for example, as hole transporting layer in organic EL devices.

FIG. 2

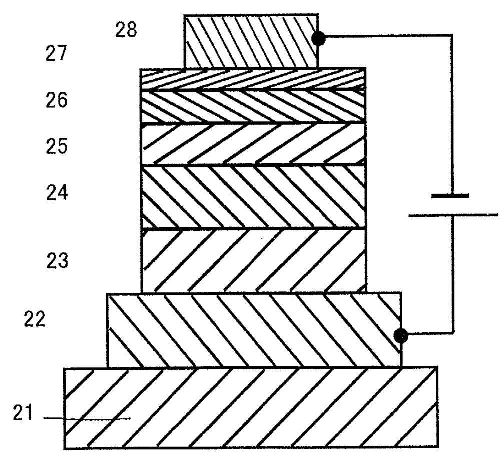


EP 1 231 252 A2

## Description

This invention relates to a material for an organic electroluminescent elemental device (hereinafter also referred to as organic EL material) based on a tertiary aryl amine which provides a structural material for an organic electroluminescent elemental device (hereinafter also referred to as organic EL device) gaining importance as a novel flat panel display and to a device made therefrom.

EL devices utilizing electroluminescence are characterized by their plain visibility due to self-luminescence and also by high impact resistance because of their being completely solid and they are drawing attention as luminescent devices in a variety of displays. These EL devices are divided into inorganic EL devices based on inorganic compounds and organic EL devices based on organic compounds. Organic EL devices can work with application of a sharply reduced voltage and, because of this advantage, intensive studies are being made to put them to practical use as display devices of the next generation.

An organic EL device is composed of layers of organic compounds containing a luminescent layer and a pair of electrodes holding the layers of organic compound in between; concretely, the basic structure is anode/luminescent layer/cathode and its modifications by suitable addition of a hole transporting layer and an electron transporting layer are known, for example, anode/hole injecting layer/hole transporting layer/luminescent layer/cathode and anode/hole injecting layer/luminescent layer/electron transporting layer/cathode. The hole transporting layer performs the function of transporting holes injected from the hole injecting layer to the luminescent layer and the electron transporting layer that of transporting electrons injected from the cathode to the luminescent layer.

It is known that interposition of the hole transporting layer between the luminescent layer and the hole injecting layer allows injection of more holes into the luminescent layer in a lower electric field and, as the hole transporting layer does not transport electrons, the electrons injected into the luminescent layer from the cathode or the electron transporting layer accumulate in the interface between the hole transporting layer and the luminescent layer with the resultant increase in luminous efficiency.

The hole transporting layer in an organic EL device is generally extremely thin on the order of 10-200 nm and, although the intensity of electric field applied to the entire device is small as described above, the intensity applied to the hole transporting layer per unit thickness is extremely large.

In addition, heat (Joule) is generated by luminescence and passage of electricity. Hence, the hole transporting layer functions in an electrically and thermally severe use environment and, with the passage of the operating time of the device, there occur deteriorating phenomena such as hindrance of luminescence by agglomeration and crystallization of molecules and destruction of the device. Moreover, any change in the hole transporting layer in the aforementioned condition of thin film adversely affects the adhesion of the interface between the neighboring hole injecting and luminescent layers and deterioration may occur from the loss of electrical contact caused by peeling.

Representative examples of organic compounds useful for various layers in EL devices are copper phthalocyanine (CuPC; hole injecting material) reported in Appl. Phys. Lett., 51, p. 913 (1987) by C. W. Tang, S. A. VanSlyke and others of Eastman Kodak Company, N,N'-di(3-methylphenyl)-N,N'-diphenylbenzidine (TPD; hole transporting material) and tris(8-qunolinolato)aluminum (Alq3; luminescent and electron transporting materials).

The hole transporting material is said to affect the life of device to the greatest extent and the use of tertiary aryl amines which have been developed as organic photosensitive electric charge transporting material is being investigated as hole transporting material and a variety of tertiary aryl amines have been proposed for hole transporting materials. For example, Japanese patent JP01-142657 A(1989) proposes TPD which is a tertiary aryl amine. U.S. Patent number 5061569 describes a variety of tertiary aryl amines containing at least two nitrogen atoms constituting triarylamines as efficient hole transporting materials. Furthermore, an article in R & D Review of Toyota Central Research Laboratory (Volume 33, Number 2, pages 3-22) describes that a variety of triphenylamine derivatives such as TPD, m-MTDATA, $\alpha$-NPB, HTM-1 and spiro-TPD perform excellently as hole transporting material and gives examples of compounds containing 1-4 nitrogen atoms constituting triarylamines.

Although no method is described for preparing tertiary aryl amines in the aforementioned publications, there is available a method based on a known reaction, typically the reaction of an aryl amine with a haloaryl compound in the presence of alkali such as potassium carbonate and copper powder or a copper halide in a solvent at 150° or more. For example, a procedure in JP09-194441 A(1997) uses N,N'-di(1-naphthyl)-4,4'-benzidine as starting material and treats it with a variety of monoiodoaryl compounds in a solvent in the presence of anhydrous potassium carbonate and copper powder to give triaryldiamines. It is possible to prepare compounds containing 2-4 nitrogen atoms constituting triarylamines at will by varying the kind and number of moles of the aryl amines and haloaryl compounds. Here, the reaction is carried out at high temperatures with the formation of a variety of impurities as byproducts and the products are purified by such means as column chromatography before use.

Now, a large number of reports have been made on the physical properties such as glass transition temperature in the course of developmental works on the aforementioned tertiary aryl amines as hole transporting materials, but none on the problems of how the impurities affect the product quality, for example, in the case of the aforementioned

Alq3. Hence, the absence of a control indicator of materials indispensable to the manufacture of practical devices with high reliability is anticipated to become a large problem. For example, according to the aforementioned U.S. Patent number 5061569, the use of tertiary aryl amine NPB as a hole transporting layer suppresses reduction of the luminance compared with the comparative examples and gives the figures of 12% and 19% as reduction of luminance after 100 and 200 hours respectively, but there is given no description at all of the gist of product qualities the materials in use must possess.

An object of this invention is to provide a high-quality organic EL material which is composed of a tertiary aryl amine and manifests an excellent performance as a hole transporting material, particularly with little reduction of luminous intensity with time, high reliability and commercial viability, and to provide an EL device made therefrom.

The present inventors have conducted studies to develop hole transporting materials of good luminescent characteristics, high reliability and commercial viability by way of improving the quality of the tertiary aryl amines described in U.S. Patent number 5061569 and elsewhere, discovered that what causes deterioration of luminescence, durability and reliability are impurities characteristically occurring in tertiary aryl amines prepared in the usual manner, investigated how to reduce the content of those impurities and found that the organic EL devices made from the tertiary aryl amines improve dramatically in durability with the decreasing content of the impurities in a range below a certain level of impurities. This invention was completed based on the finding that controlling the trace impuriites at or below a certain level makes it possible to obtain highly durable organic EL devices.

The present invention relates to an organic electroluminescent material comprising a tertiary amine containing 2 to 4 nitrogen atoms each forming a triarylamine wherein the organic electroluminescent material comprises 1 wt.% or less of impurity compounds (A) possessing one less nitrogen atom forming a triarylamine group than said tertiary aryl amine compound and/or 2 wt.% or less of impurity compounds (B) possessing one more nitrogen atom forming a triarylamine group than said tertiary aryl amine compound. Aryl is preferably a substituted orunsubstituted phenyl, biphenyl or napthyl group.

The organic electrominescent material can be used in an organic EL device.

This invention also relates to a material for an organic EL device wherein the aforementioned tertiary aryl amine is selected from compounds represented by ;

$$(Ar_1Ar_2\ N\text{-})_2\text{-}Ar_3 \qquad (1)$$

$$(Ar_1Ar_2N\text{-}\ Ar_3\text{-})_3\text{-}N \qquad (2)$$

$$(Ar_1Ar_2N\text{-}\ Ar_3\text{-})_2\text{-}N\text{-}Ar_4 \qquad (3)$$

and

$$(Ar_1Ar_2\ N\text{-})_4\text{-}Ar_5 \qquad (4)$$

in formulas (1) to (4), $Ar_1$, $Ar_2$ and $Ar_4$ are independently monovalent aryl groups, $Ar_3$ is independently a divalent aryl group and $Ar_5$ is a tetravalent aryl group.

Furthermore, this invention relates to a material for an organic EL device wherein the aforementioned tertiary aryl amine is a compound represented by ;

$$A_1\text{-}G\text{-}A_2 \qquad (5)$$

in formula (5), $A_1$ and $A_2$ are independently diarylamino groups and G is a divalent aryl group.

Still more, this invention relates to a material for an organic EL device wherein the aforementioned tertiary aryl amine is N,N'-di(naphthalen-1-yl)-N,N'-diphenylbenzidine (hereinafter referred to as NPB).

In addition, this invention relates to an organic EL device wherein the aforementioned material for an organic EL device is incorporated in the hole transporting layer or luminescent layer of the device.

Still further, this invention relates to the aforementioned organic EL device whose operating time with 10% attenuation of the initial luminance exceeds 100 hours in the life test. Still more, this invention relates to a process for preparing the aforementioned organic EL material which comprises purifying by sublimation or distillation the crude

tertiary aryl amine obtained by the reaction of a haloaryl compound containing one or more halogen atoms on the aromatic ring with an aryl amine in the presence of a catalyst and reducing compound (A) to 1 wt% or less or compound (B) to 2 wt% or less. This invention will be described in detail below.

The tertiary aryl amines of this invention are compounds containing 2-4 nitrogen atoms, each of which is directly linked to 3 aromatic rings to form a triarylamine, and do not contain extra nitrogen atoms other than those forming hetero rings. The aromatic rings are monocyclic, condensed or noncondensed polycyclic or heteroaromatic and may be substituted only to the extent that the characteristics of organic EL materials are kept intact. Compound (A) contains triarylamines possessing one less nitrogen atom than the tertiary aryl amine intended for an organic EL material and, as described above, does not contain extra nitrogen atoms other than those forming hetero rings. That is, compound (A) has a structure formed by removing one diarylamine from the aromatic ring of the tertiary aryl amine. Compound (B) contains triarylamines possessing one more nitrogen atom constituting than the tertiary aryl amine intended for an organic EL material and, as described above, does not contain extra nitrogen atoms other than those forming hetero rings. That is, compound (B) has a structure formed by attaching one too many diarylamine to the aromatic ring of the tertiary aryl amine.

The crude tertiary aryl amine of this invention refers to a tertiary aryl amine which contains compound (A) or compound (B) or both in a quantity equal to or exceeding the specified level and it may be not only the material obtained from the manufacturing step but also the material preliminarily purified after the manufacture.

Depending upon the mode of usage, a tertiary aryl amine is adequate for use in this invention if the content of either one of compounds (A) and (B) is below a specified level. However, if the contents of both compounds are below a specified level, a good result is obtained regardless of the mode of usage and hence a higher use value is realized.

The tertiary aryl amines here are required to possess characteristics suitable for organic EL materials and, in addition, to exhibit a relatively high glass transition temperature (Tg), for example, 50° or more, and a vapor pressure of a specified level below the decomposition temperature they are submitted to lamination by vapor deposition.

It has been surmised that the problems associated with the luminous intensity and the durability of EL devices arise from the insufficient quality of hole transporting materials, but no attempt has been made to elucidate how much of what impurities are present in the hole transporting materials or how the impurities affect the characteristics of EL devices. Still less, there has been a complete lack of concept that specific impurities present in hole transporting materials peculiarly deteriorate the luminescent materials emitting light of specific wavelength. Moreover, no study has been made on how the impurities affect luminescence when such hole transporting materials are converted into luminescent materials. In consequence, naturally no means has been shown to solve the aforementioned problems by way of improving the product quality and a prevailing thinking has been that there is a limit to the product quality of the conventional tertiary aryl amines available so far and this in turn limits the life of El devices made therefrom.

The Ullmann reaction is generally cited in literature for the preparation of tertiary aryl amines and analysis of the impurities contained in such tertiary aryl amines showed that the crude product after the reaction contained approximately 5% or more of compound (A) and approximately 5% or more of compound (B). The Ullmann reaction used for the synthesis of tertiary aryl amines normally requires high temperature (200°C or so) and, for this reason, the reaction is known to produce substantially insoluble tarry matters and a variety of other byproducts. Therefore, the tertiary aryl diamines prepared in this manner inevitably contain large quantities of a variety of byproducts and the aforementioned compounds (A) and (B) were presumably such byproducts.

There is another possibility, on the basis of reaction mechanism, of compounds (A) and (B) originating from impurities present in the starting raw materials. However, analysis of the starting materials in use has not revealed the presence of even traces of 1- or 3-substituted impurities from which the compounds (A) and (B) originate and thus has confirmed that the impurities did not originate from the raw materials. Moreover, a change in the reaction time or temperature increases or decreases the quantity of the aforementioned impurities and this supports the idea that the impurities occur as byproducts from the tertiary aryl amine or intermediates thereof formed in the reaction system.

As for the synthesis of tertiary aryl amines, a method applicable under mild reaction conditions with the use of a trialkylphosphine and a palladium compound as catalyst was recently reported in JP10-139742 A(1998), but even this method was confirmed to give approximately 3% of compound (A) and approximately 10% of compound (B).

Granted that it is difficult to suppress the formation of these byproducts in the course of the reaction, it is conceivable to resort to a means of allowing them to form in the reaction and remove them after the reaction. The removal is generally effected by an adsorptive means such as silica gel column chromatography. However, those impurities which have the structure of compound (A) or (B) are extremely difficult to remove completely because of the structural similarity between the impurities and the target tertiary aryl amine.

Another approach for the removal of the impurities is the use of apparatuses for "molecular distillation" and "purification by sublimation" and purifying apparatuses made of glass for the laboratory use are publicly known; however, the collecting part of the apparatus, because of lack of precise temperature control there, condenses and collects simultaneously not only the target purified product but also impurities such as compounds (A) and (B) boiling close to

the target product and this condition prevents sufficient purification.

As described above, the crude tertiary aryl amine prepared in the usual manner is high in the content of the aforementioned compounds (A) and (b) and ordinary purifying methods are not effective for reducing the content of impurities any further. Moreover, since the durability of organic EL devices does not improve unless the content of impurities (A) and (B) is reduced to below a specified level, the purification of the crude tertiary aryl amine by the conventional methods could not reduce the content of compounds (A) and (B) to such a low level as to improve the durability of organic EL devices. In consequence, it has generally been held that there is necessarily a limit in quality to the conventional tertiary aryl amine and this in turn imposes a limit to any attempt to extend the life of EL devices.

An organic EL material of this invention is composed of the aforementioned tertiary aryl amine. Such tertiary aryl amine is a compound selected from the compounds represented by the aforementioned formulas (1)-(4) or is one of the compounds represented by the aforementioned formula (5). In formula (1), $Ar_1$ and $Ar_2$ are independently monovalent aryl groups, preferably one of them assuming a condensed ring structure, and $Ar_3$ is a divalent aryl group, preferably 1,4-phenylene or 4,4'-biphenylene. In formula (2), $Ar_1$ and $Ar_2$ are independently monovalent aryl groups, preferably both assuming a monocyclic structure, and $Ar_3$ is a divalent aryl group, preferably 1,4-phenylene or 4,4'-biphenylene. In formula (3), $Ar_1$, $Ar_2$ and $Ar_4$ are independently monovalent aryl groups, preferably each assuming a monocyclic structure, and $Ar_3$ is a divalent aryl group, preferably 1,4-phenylene or 4,4'-biphenylene. In formula (4), $Ar_1$ and $Ar_2$ are independently monovalent aryl groups, preferably each assuming a monocyclic structure, and $Ar_5$ is a tetravalent aryl group, preferably a tetravalent group such as the dimer formed by linking two fluorene rings at the 9-position.

In formula (5), $A_1$ and $A_2$ are independently diarylamino groups and it is advantageous from the standpoint of manufacture if the two are identical. The group G is a divalent aryl group, preferably 1,4-phenylene or 4,4'-biphenylene. As described above, the aromatic rings may have substituents as long as the substituents remain unharmful for the performance of EL materials. Such substituents include lower alkyl groups like methyl and ethyl, halogens and alkoxy groups. Furthermore, an alkylene group such as methylene, oxygen or sulfur may intervene between an aryl group and the aromatic ring linked to the tertiary nitrogen atom.

The following reactions are used for the synthesis of compounds represented by the aforementioned formulas (1)-(4).

$$(1): (Ar_1Ar_2N\text{-})_2\text{-}Ar_3 \leftarrow 2\ Ar_1Ar_2N\text{-}H + (X\text{-})_2Ar_3$$

$$(2): (Ar_1Ar_2N\text{-}Ar_3\text{-})_3N \leftarrow 3\ Ar_1Ar_2N\text{-}H + (X\text{-}Ar_3\text{-})_3\text{-}N$$

$$(3): (Ar_1Ar_2N\text{-}Ar_3\text{-})_2N\text{-}Ar_4 \leftarrow 2\ Ar_1Ar_2N\text{-}H + (X\text{-}Ar_3\text{-})_2N\text{-}Ar_4$$

$$(4): (Ar_1Ar_2N\text{-})_4\text{-}Ar_5 \leftarrow 4\ Ar_1Ar_2N\text{-}H + (X\text{-})_4Ar_5$$

The compounds (A) and (B) which form in the aforementioned reactions (1)-(4) include the following.

$$(1): (A)\ Ar_1Ar_2N\text{-}Ar_3\text{-}H,\ (B)\ [(Ar_1Ar_2\ N\text{-})_2\text{-}Ar_3][\text{-}NAr_1Ar_2]$$

$$(2): (A)\ (Ar_1Ar_2N\text{-}Ar_3)_2N\text{-}(HAr_3),\ (B)\ [(Ar_1Ar_2N\text{-}Ar_3)_3N][\text{-}NAr_1Ar_2]A]$$

$$(3): (A)\ (Ar_1Ar_2N\text{-}Ar_3\text{-})(HAr_3\text{-})N\text{-}Ar_4,\ (B)\ [(Ar_1Ar_2N\text{-}Ar_3\text{-})_2\ N\text{-}Ar_4][\text{-}NAr_1Ar_2]$$

$$(4): (A)\ (Ar_1Ar_2N\text{-})_3\text{-}Ar_5H,\ (B)\ [(Ar_1Ar_2N\text{-})_4\text{-}Ar_5][\text{-}NAr_1Ar_2]$$

$$(5): (A)\ A_1\ \text{-}G\text{-}H,\ (B)\ (A_1\text{-}A_2)\ (\text{-}A_1)$$

The way the compounds (B) are written above means that the group $[\text{-}NAr_1Ar_2]$ or $[\text{-}A_1]$ on the right side replaces a

hydrogen atom on the carbon atom constituting any one of aromatic groups shown in [] on the left side or the aromatic groups present in $Ar_1$-$Ar_5$, or G.

A preferable example of tertiary aryl amine is shown in a generalized way by the following formula (6).

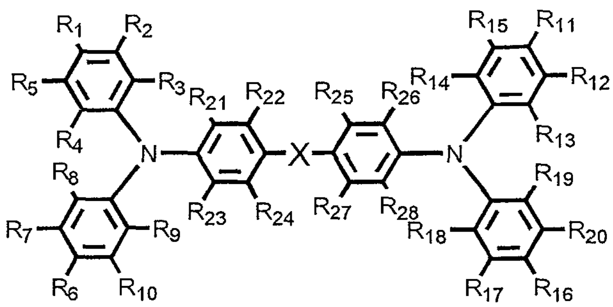

(6)

On the basis of the compound represented by the aforementioned formula (6) as the tertiary aryl amine of this invention, the impurity compound (A) may be written as a compound represented by the following formula (7) while the impurity compound (B) may be written as a compound formed by ring-substituting the compound represented by the aforementioned formula (6) with one group represented by the following general formula (8).

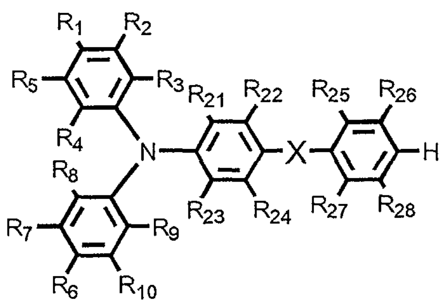

(7)

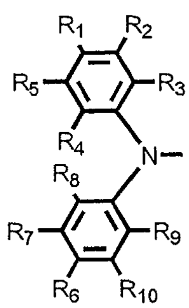

(8)

In the aforementioned formulas (6)-(8), $R_1$-$R_{20}$ are independently hydrogen, alkyl group, alkoxy group, thioalkoxy group, mono- or di-substituted amino group or monocyclic or condensed polycyclic group. Moreover, the neighboring pair of $R_1$-$R_{20}$ may form a cycloalkyl or aryl group. The group X denotes a carbon to carbon bond, an alkylene group, -O-, -S-, > C=O, > $SO_2$, -$SiR_{29}(R_{30})$- or -$NR_{31}$-. The groups $R_{21}$-$R_{31}$ denote alkyl group, monocyclic group or substituted or unsubstituted condensed polycyclic group.

The alkyl groups in the aforementioned formulas (6)-(8) include methyl, ethyl, propyl, n-butyl, sec-butyl, tert-butyl, pentyl, hexyl, octyl, stearyl, trichloromethyl, trifluoromethyl and benzyl. The alkoxy groups include methoxy, ethoxy, propoxy, n-butoxy, sec-butoxy, tert-butoxy, pentyloxy, hexyloxy, octyloxy, stearyloxy and trifluoromethoxy. The thioalkoxy groups include methylthio, ethylthio, propylthio, n-butylthio, sec-butylthio, tert-butylthio, pentylthio, hexylthio,

octylthio, stearylthio and trifluoromethylthio. The mono- or di-substituted amino groups include methylamino, dimethylamino, ethylamino, diethylamino, dipropylamino, dibutylamino, diphenylamino, ditolylamino, dibiphenylylamino, benzylphenylamino and dibenzylamino.

The monocyclic groups include monocyclic cycloalkyl, monocyclic aryl, and monocyclic heterocyclic. The monocyclic cycloalkyl groups include those with 4-8 carbon atoms such as cyclobutyl, cyclopentyl, cyclohexyl, cycloheptyl and cyclooctyl. The monocyclic aryl group is typically phenyl and the monocyclic heterocyclic groups include thienyl, furanyl, pyrrolyl, pyrazolyl, pyridyl, pyrazyl, pyrazinyl, pyrimizinyl, pyridanyl, oxazolyl, thiazolyl, oxadiazolyl, thiadiazolyl and imidadiazolyl. The condensed polycyclic groups include condensed polycyclic aryl groups and condensed polycyclic heterocycles. Examples of the former are naphthyl, anthranyl, benzanthranyl, phenanthrenyl, fluorenyl, acenaphthyl, azulenyl and triphenylene while examples of the latter are indolyl, quinolyl, isoquinolyl, carbazolyl, acridinyl, phenazinyl, benzoxazolyl and benzothiazolyl.

The cycloalkyl groups which may be formed by the neighboring substituents include cyclobutyl, cyclopentyl, cyclohexyl, cycloheptyl and cyclooctyl. The compounds containing aryl rings which may be formed by the neighboring substituents include benzene, naphthalene, anthracene, phenanthrene, fluorene, acenaphthalene, pyrene, biphenyl, terphenyl and triphenylene. The aforementioned monocyclic or condensed polycyclic compounds may be substituted by the aforementioned alkyl groups, alkoxy groups, alkylthio groups, mono- or di-substituted amino groups or monocyclic or condensed polycyclic groups.

The crude tertiary aryl amine useful for an organic EL material of this invention can be prepared by a known method such as described above, for example, by the Ullmann reaction to be described later in the examples or by the reaction using a trialkylphosphine and a palladium compound as a catalyst. The yield of these reactions is on the order of 50-90 mol% and the crude tertiary aryl amine obtained by removing the unreacted raw materials by an ordinary means such as distillation, recrystallization and gel chromatography is purified further to provide the tertiary aryl amine useful for this invention.

The crude tertiary aryl amine shows a purity of 90-95%. The contents of compounds (A) and (B) vary with the kind, reaction conditions and purification conditions of the target tertiary aryl amine and normally they range respectively from several % to 10%. In the case of NPB obtained in accordance with an ordinary separation and purification procedure, the content of compound (A) is in the range of 1.5-3 wt% while that of compound (B) is in the range of 3-6 wt%.

It appears likely that tertiary aryl amines such as the one with the aforementioned purity have been used as prepared or in the condition of insufficient purification for organic EL materials in the past. In this invention, the purification is carried out further until the content of compound (A) is reduced to 1 wt% or less, preferably 0.5 wt% or less, more preferably substantially 0 wt% (that is, below the detection limit or 0.01 wt% or less).

As long as the content of compound (A) remains in the range above 1 wt%, the luminescent life of green light does not improve appreciably by any reduction of the content effected within that range. However, the operating time in which the initial luminance of green light attenuates 10% can be made to exceed 50 hours in the life test of organic EL devices if the content of compound (A) is reduced to 1 wt% or less or to exceed 100 hours if reduction to substantially 0 wt% is attained.

Likewise, the content of compound (B) is reduced to 2 wt% or less, preferably 1 wt% or less. Compound (B) arises by substituting replaceable hydrogen atoms on the aromatic rings of the compound represented by formula (6) with the substituent represented by formula (8); a plurality of such compounds are conceivable and the principal ones are supposedly those formed by substituting $R_1$, $R_6$, $R_{11}$ and $R_{16}$ in formula (6) with the substitutent represented by formula (8). The content of compound (B) means the content of the sum of these compounds.

As long as the content of compound (B) remains in the range exceeding 2 wt%, the luminescent life of blue light does not improve appreciably by any reduction effected within that range. However, the operating time in which the initial luminance of blue light attenuates 10% can be made to exceed 50 hours in the life test of organic EL devices if the content of compound (B) is reduced to 2 wt% or less or to exceed 100 hours if reduction to 1 wt% or less is attained.

Claim 6 of this invention specifies the operating time in which the initial luminance attenuates 10% and this time is measured according to the procedure to be described later in the examples. The time in question varies with the color of emitted light and it is satisfactory if the time exceeds 100 hours with 10% attenuation of the initial luminance for any one color, more satisfactory if the same holds for two or more colors. Setting a material containing 1.2 wt% of compound (A) and 2.4 wt% of compound (B) as standard, it is preferable for any material to exhibit 1.5-fold or more of the standard operating time with 10% attenuation of the initial luminance. In this case too, it is satisfactory if any one color meets this requirement when determined as described later in the examples and more satisfactory if two colors or more do so.

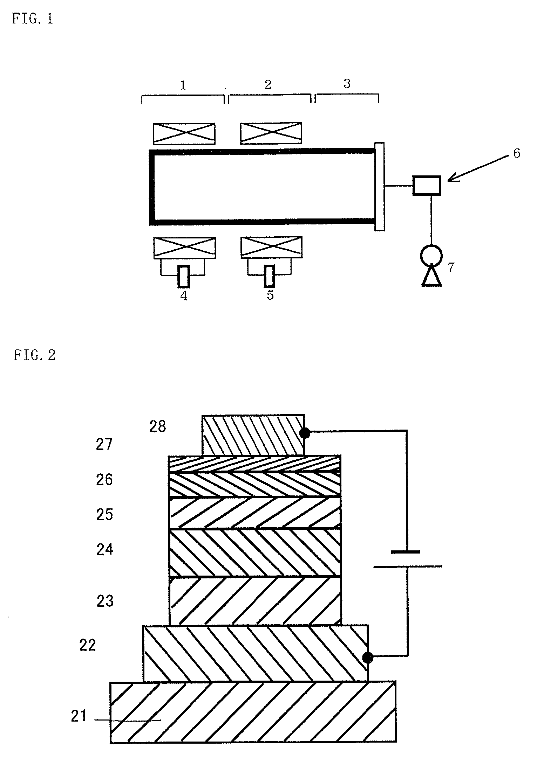

A variety of methods such as recrystallization, chromatographic separation, distillation and sublimation are conceivably applicable to the preparation of a tertiary aryl amine of the aforementioned purity (hereinafter also referred to as target compound). However, the conventional methods do not improve the purity sufficiently and give low yield and it is advantageous to adopt a special purifying procedure based on vacuum distillation or vacuum sublimation. Now, the only difference between purification by distillation and purification by sublimation is that the former is applied

to those compounds which vaporize after liquefaction while the latter to those compounds which sublime; therefore, in explanation of the purifying method, purification by distillation implies purification by sublimation unless otherwise specified. The apparatus for purification by vacuum distillation here is not restricted in any other respect than that its collecting zone (collecting hereinafter meaning condensing or solidifying) can be heated to a specified temperature (temperature range in the case of NPB: 250-350°, preferably 280-330°) in order to collect compound (A), the target compound and compound (B) at locations separated from one another. However, it is advantageous to employ a method designed to carry out purification by vacuum distillation under rigid control of the temperature in the collecting zone. A preferable example of the purifying apparatus is schematically illustrated in Fig. 1.

Fig. 1 is a cross-sectional view of an example of the apparatus to practice the purifying process of this invention.

Fig. 2 is a cross-sectional view of an example of the organic EL device of this invention.

In Fig. 1, the main body of the apparatus comprises a heating zone 1, a collecting zone 2 and a collecting zone 3 and it is evacuated by a vacuum pump 7, heated or cooled by supplying a heat transfer medium, and controlled independently by temperature controllers 4 and 5. It is possible to hold each of the heating zones 1 and 2 in a specified temperature range by supplying a heat transfer medium with a sufficient amount of heat and controlling the temperature rigidly. From the stream containing the evaporated target compound, the purified target compound or the intended product is collected in the collecting zone 2 kept at a temperature which is higher than that for collecting compound (A) or yields a sufficiently high vapor pressure and is lower than that for collecting the target compound while low-quality tertiary aryl amine containing much of the impurity compound (A) is collected in the collecting zone 3. By suitably controlling the temperature of the heating zone 1 at a level below the vaporization temperature of compound (B) or at a temperature yielding a sufficiently low vapor pressure, it is possible to leave low-quality tertiary aryl amine containing much of the impurity compound (B) in the heating zone 1. Moreover, those volatile impurities which do not separate out in the collecting zone 3 are collected in a cooling trap 6. As for the heating means, indirect heating by a heat transfer medium or any other means may be adopted if it allows zone-by-zone temperature control of the aforementioned heating and collecting zones with good response and precision.

In this invention, it is possible to separate compounds (A) and (B) from the target compound efficiently and reduce the content of these impurities to 1 wt% or less with the use of the apparatus shown in Fig. 1 while carrying out purification by utilizing the difference in boiling point due to the difference in molecular weight. A preferable degree of vacuum is 10 Torr or less, preferably 1 Torr or less. The temperature in the heating zone is kept at or above the vaporization temperature at the aforementioned degree of vacuum of the target compound or tertiary aryl amine (300-400° , preferably 340-390° in the case of NPB), and the temperature in the collecting zones is kept at or below the point which is lower by 50° than the boiling point (250-350°, preferably 280-330° in the case of NPB). case of NPB).

The organic EL material of this invention composed of the purified tertiary aryl amine is used in an organic EL device, preferably in the hole transporting layer.

The organic EL device has no structural restriction other than that it has the organic luminescent layer or the essential structural layer interposed between a pair of electrodes and a desirable example is a structure composed of an organic luminescent layer, a hole injecting layer and an electron injecting layer interposed between a pair of electrodes. A preferable example is illustrated schematically in Fig. 2.

Fig. 2 is a schematic drawing showing a layered structure of an organic EL device composed of glass substrate 21/anode 22/hole injecting layer 23/hole transporting layer 24/luminescent layer 25/electron transporting layer 26/electron injecting layer27/cathode 28 and the tertiary aryl amine of this invention is used in the hole transporting layer.

There can be other layered structures such as the following besides the aforementioned:

Anode/organic luminescent layer/cathode
Anode/hole injecting layer/organic luminescent layer/cathode
Anode/organic luminescent layer/electron injecting layer/cathode
Anode/hole injecting layer/organic luminescent layer/electron injecting layer/cathode

Furthermore, a light-absorbing diffusion layer may be interposed if necessary.

There is no restriction on in what layer the tertiary aryl amine of this invention is used and it may be used in a hole injecting layer, organic luminescent layer, electron transporting layer or electron injecting layer.

The luminescent layer, hole injecting layer and electron injecting layer are formed by vapor deposition, spin coating or casting to a film thickness of 10-1,000 nm, preferably 20-200 nm.

The substrate is made from a plate of glass such as soda glass, nonfluorescent glass, phosphate glass and silicate glass, quartz, a plate of plastics such as acrylic resins, polyethylene, polyesters and silicones, a film of plastics, a plate of metal and a foil of metal.

Materials useful for the anode include metals, alloys, and electrically conductive compounds respectively having a large work function or a mixture thereof. Concrete examples are gold, CuI, indium tin oxide (ITO), $SnO_2$ and

ZnO. Materials useful for the cathode include metals, alloys, and electrically conductive compounds respectively having a small work function. Concrete examples are Na, Na-K alloy, Mg, Li, Mg-Ag alloy, Al-Li alloy, In and rare earth metals.

In order to take out light, at least one of the electrodes should be made transparent or translucent and it is proper to set the transmission on the side for taking out light higher by 10%. Furthermore, it is preferable to set the sheet resistance as electrode at 100Ω/ □ or less.

Materials useful for the organic luminescent layer include, in addition to the compounds of this invention, aromatic compounds such as tetraphenylbutadiene, metal complexes such as 8-hydroxyquinoline-aluminum complex, cyclopentadiene derivatives, perinone derivatives, oxadiol derivatives, bisstyrylbenzene derivatives, perylene derivatives, coumarin derivatives, rare earth complexes, bisstyrylpyrazine derivatives, p-phenylene compounds, thiadiazolopyridine derivatives, pyrrolopyridine derivatives and naphthyridine derivatives, all of them known publicly.

Materials useful for the hole injecting layer include triazole compounds, oxadiazole derivatives, imidazole derivatives, polyarylalkanes, pyrazoline and pyrazolone derivatives, phenylenediamine derivatives, aryl amines, oxazole derivatives, styrylanthracene derivatives, fluorene derivatives, hydrazone derivatives, stilbene derivatives, porphyrins, aromatic tertiary amines and styrylamines, butadiene compounds, polystyrene derivatives, hydrazone derivatives, triphenylmethane derivatives and tetraphenylbenzidine derivatives. Particularly preferable are porphyrins, aromatic tertiary amines and styrylamines.

Electron injecting compounds capable of transporting electrons and useful for the electron injecting layer include, in addition to the compounds of this invention, nitro-subsituted fluorene derivatives, thiopyran dioxide derivatives, diphenoquinone derivatives, tetracarboxyl-containing perylene derivatives, anthraquinodimethan derivatives, fluorenylidenemethane derivatives, anthrone derivatives, oxadiazole derivatives, perinone derivatives and quinoline complex derivatives.

In order to improve the heat resistance of the luminescent layer, hole injecting layer and electron injecting layer, each constituting the aforementioned organic compound layer, it is allowable to introduce a polymerizable substitutent to the constituent organic compound and allow the substituent to polymerize before, during or after the formation of film.

In the aforementioned devices, the use of organic EL materials of this invention as hole transporting material was found to provide EL devices with markedly improved luminance and durability compared with the conventional EL devices. In this invention, the contents of compounds (A) and (B) can be determined with the aid of HPLC (high performance liquid chromatography) and a UV detector. As there is a certain relationship between the peak area ratio and the weight ratio at 254 nm, the contents in wt% of compounds (A) and (B) of this invention can readily be computed from the aforementioned peak area (%).

The reason why the durability is affected adversely by the aforementioned compounds (A) and (B) present among a large variety of impurities of the tertiary aryl amine, particularly the durability of emitted green light by compound (A) and that of emitted blue light by compound (B), is presumably an occurrence of accelerated changes in the structure of the thin NPB layer (hole transporting layer) and in the condition of interface between the NPB layer and the neighboring layer in the device, but the details are not known.

Examples

This invention will be described in detail below with reference to examples. Unless otherwise specified, the percent (%) refers to wt%.

Synthetic Example 1

In a 300cc three-necked flask fitted with a condenser and a thermometer were placed 14.6 g of 4,4'-diiodobiphenyl, 19.7 g of 1-naphthylphenylamine, 150 g of nitrobenzene, 39.8 g of potassium carbonate and 3.4 g of copper (I) iodide, the contents were heated to reflux temperature in a stream of nitrogen and further heated with stirring for 15 hours. Upon completion of the reaction, the mixture was diluted with 200 g of toluene, the insoluble matters were filtered off and the filtrate was distilled under reduced pressure to strip off the solvent.

The residue was purified by silica gel chromatography to give 10.0 g of tertiary aryl amine (NPB). The product was analyzed by HPLC as follows: NPB, 84%; compound (A), 4%; compound (B), 7%.

Synthetic Example 2

A catalyst solution was prepared by heating 0.02 g of palladium acetate, 0.06 g of tri-tert-butylphosphine and 10 g of ortho-xylene in a 50cc eggplant type flask at 80°C for 15 minutes.

In a 300cc three-necked flask fitted with a condenser and a thermometer were placed 3.1 g of 4,4'-diiodobiphenyl, 5.0 g of 1-naphthylphenylamine, 2.2 g of sodium tert-butoxide and 100 g of ortho-xylene and the contents were

heated to 80°C in a stream of nitrogen. To the resulting solution was added the catalyst solution previously prepared, the temperature was raised to 120°C and the mixture was heated continuously with stirring for 2 hours.

Upon completion of the reaction, the reaction mixture was cooled, diluted with 200 g of ortho-xylene, the diluted mixture was transferred to a separatory funnel and the organic layer was washed with a saturated aqueous solution of sodium chloride. After separation of oil from water, the organic layer was dried over anhydrous sodium sulfate and concentrated. The residue was purified by silica gel chromatography to give 2.9 g of tertiary aryl amine (NPB). The product was analyzed by HPLC as follows: NPB, 80%; compound (A), 2%; compound (B), 15%.

Purification Example 1

With the use of the purifying apparatus shown in Fig. 1, 10.0 g of NPB prepared in the same manner as in Synthetic Example 1 and exhibiting an HPLC purity of 84% was purified. The heating zone 1 and collecting zone 2 are either heated or cooled by supplying a heat transfer medium and controlled independently.

The system was evacuated to 0.1 Torr by the vacuum pump 7, the temperatures of the heating zone and the collecting zone 2 were kept at 330°C and 300°C respectively, the difference in temperature of the heat transfer medium between inlet and outlet was kept within 2 □, the temperature was raised for 3 hours, and NPB was collected on the inner surface of the glass wall of the collecting zone 2. The metal outer tube of the purifying apparatus is approximately 6 cm in diameter and 100 cm in length and NPB collected in the collecting zone 2 weighed 5.6 g, exhibited an HPLC purity of 99% and contained 0.5% or less each of compounds (A) and (B).

Purification Example 2

With the use of the same purifying apparatus as in Purification Example 1, 10.0 g of NPB prepared in the same manner as in Synthetic Example 2 and exhibiting an HPLC purity of 80% was purified.

The system was evacuated to 0.5 Torr by the vacuum pump 7, the temperatures of the heating zone and the collecting zone 2 were kept at 380 °C and 280 °C respectively, the difference in temperature of the heat transfer medium between inlet and outlet was kept within 2 °C, the temperature was raised for 3 hours, and NPB was collected on the inner surface of the glass wall of the collecting zone 2. NPB collected in the collecting zone 2 weighed 3.6 g, exhibited an HPLC purity of 99% and contained 0.5% or less each of compounds (A) and (B).

Comparative Purification Example 1

With the use of an apparatus for purification by sublimation composed of an outer glass tube and an inner glass tube, 2.0 g of NPB prepared in the same manner as in Synthetic Example 1 and exhibiting an HPLC purity of 84% was purified while cooling the collecting zone 10 by supplying nitrogen gas.

The system was evacuated to 2.0 Torr by the vacuum pump, the heating zone was kept at 390 °C and NPB was collected on the surface of the inner glass wall in the collecting zone. NPB collected in the collecting zone weighed 1.4 g, exhibited an HPLC purity of 93% and contained 3% of compound (A) and 3% of compound (B).

Identification of Compound (A)

Compound (A) was isolated and analyzed by $^1$H-NMR and FD-MS (field desorption mass spectrometry) and the results are as follows.

$^1$H-NMR (400 MHz, $CDCl_3$, 27 °C):δ 6.96, dd, 1H (J = 7.3 Hz); 7.08, dd, 4H (J = 8.5, 7.8 Hz); 7.21-7.35, m, 3H; 7.36-7.55, m, 10H; 7.78, d, 1H (J = 8.3 Hz); 7.89, d, 1H (J = 8.1 Hz); 7.96, d, 1H (J = 8.5 Hz)

MS: m/z 371 ($M^+$)

The results have confirmed that the impurity compound (A) has a structure represented by the aforementioned formula (7).

Identification of Compound (B)

The impurities present in NPB shown in Synthetic Examples 1 and 2 were analyzed by LC-MS (liquid chromatography-mass spectrometry) under the following conditions; NPB (m/z 588) and compound A (m/z 371) were observed at retention times of approximately 13 and 10 minutes respectively in liquid chromatography and, in addition, two peaks [both of them m/z 805 ($M^+$)] were observed at retention times of approximately 19 and 21 minutes respectively.

LC-MS conditions

Column; TSK-GEL ODS-80TS, φ4.6 × 250 mm, available from Tosoh Corporation
Mobile phase; acetonitrile (100%), 1 ml/minute
Matrix; nitrobenzyl alcohol (1% solution in acetonitrile), 0.25 ml/minute
As a result, it has been confirmed that compound (B) is mainly composed of two kinds of compounds, B' and B", which are formed by substituting a hydrogen atom on the aromatic ring of the compound represented by formula (6) with a substituent represented by the aforementioned formula (8). A compound represented by formula (6) being NPB here, it is easy to understand what the substituent represented by formula (8) is.

Samples 1-7 differing in the composition of impurities were prepared by changing the temperature of the heating zone and collecting zone of the apparatus shown in Fig. 1. The results of HPLC analysis of the samples are shown in Table 1. Organic EL devices were prepared using Samples 1-7 and their performance was evaluated.

Table 1

| | NPB | Compound (A) | Compound (B) |
|---|---|---|---|
| Sample 1 | 100.0 | 0 | 0 |
| Sample 2 | 99.4 | 0.5 | 0 |
| Sample 3 | 99.3 | 0 | 0.7 |
| Sample 4 | 98.0 | 0.4 | 1.5 |
| Sample 5 | 96.3 | 0.5 | 3.1 |
| Sample 6 | 96.2 | 1.1 | 2.5 |
| Sample 7 | 95.8 | 1.5 | 2.5 |

Example 1

A glass substrate provided with a 200 nm-thick transparent ITO electrode was treated with ultrasonic wave using a commercial neutral detergent, pure water and acetone, cleaned with ethanol vapor, and cleaned further with UV/ozone.

Copper phthalocyanine as a hole injecting layer was deposited on the cleaned glass substrate to a thickness of 50 nm at a degree of vacuum of $1.0 \times 10^{-3}$ Pa or less and a deposition rate of 0.3 nm/second and then a hole transporting layer was formed from Sample 1 to a thickness of 50 nm at a degree of vacuum of $1.0 \times 10^{-3}$ Pa or less and a deposition rate of 0.3 nm/second.

Thereafter, a luminescent layer was formed from tris(8-quinolinolato)aluminum on the hole transporting layer to a thickness of 50 nm at a degree of vacuum of $1.0 \times 10^{-3}$ Pa or less and a deposition rate of 0.3 nm/second.

Following this, an electron injecting layer was formed from lithium fluoride on the luminescent layer to a thickness of 0.1 nm at a degree of vacuum of $1.0 \times 10^{-3}$ Pa or less and a deposition rate of 0.05 nm/second.

Finally, aluminum was deposited as cathode to a thickness of 100 nm at a degree of vacuum of $1.0 \times 10^{-3}$ Pa or less and a deposition rate of 1.0 nm/second.

The organic EL device thus prepared was driven continuously under application of direct current in a dry atmosphere at a constant current density of 10 mA/cm$^2$. Emission of green light with a voltage of 5.0 V and a luminance of 350 cd/m$^2$ was confirmed initially and it took 105 hours for the luminance to attenuate 10% or 290 hours to attenuate 20%.

Examples 2-5

As in Example 1, organic EL devices were prepared using Samples 2-5 as hole transporting material and the time in which the luminance of each device attenuated 20% was measured.

Comparative Examples 1 and 2

As in Example 1, organic EL devices were prepared using Samples 6 and 7 as hole transporting material and the time in which the luminance of each device attenuated 10% and 20% was measured.

The results are summarized in Table 2.

Table 2

| | Sample | 10% attenuation time (hr) | Relative ratio | 20% attenuation time (hr) | Relative ratio |
|---|---|---|---|---|---|
| Example 1 | 1 | 105 | 2.3 | 290 | 2.6 |
| Example 2 | 2 | 65 | 1.4 | 200 | 1.8 |
| Example 3 | 3 | 105 | 2.3 | 290 | 2.6 |
| Example 4 | 4 | 70 | 1.6 | 210 | 1.9 |
| Examples 5 | 5 | 60 | 1.3 | 180 | 1.6 |
| Comp. ex. 1 | 6 | 45 | 1.0 | 110 | 1.0 |
| Comp. ex. 2 | 7 | 45 | 1.0 | 110 | 1.0 |

It is seen from Table 2 that the content of the impurity compound (A) and the attenuation of emitted green light are closely related to each other and the impurity compound (B) does not exert an appreciable influence and that the attenuation of emitted green light declines markedly with a decreasing content of compound (A) in the range below 1 wt%. Moreover, the content of compound (A) should necessarily be reduced to 1 wt% or less in order that the time for 10% attenuation of luminance may exceed 50 hours.

Example 6

A glass substrate provided with a 200 nm-thick transparent ITO electrode was treated with ultrasonic wave using a commercial neutral detergent, pure water and acetone, cleaned with ethanol vapor, and cleaned further with UV/ozone.

Copper phthalocyanine as a hole injecting layer was deposited on the cleaned glass substrate to a thickness of 50 nm at a degree of vacuum of $1.0 \times 10^{-3}$ Pa or less and a deposition rate of 0.3 nm/second and then a hole transporting layer was formed from Sample 1 to a thickness of 50 nm at a degree of vacuum of $1.0 \times 10^{-3}$ Pa or less and a deposition rate of 0.3 nm/second.

Thereafter, a luminescent layer was formed from IDE-120 (available from Idemitsu Kosan Co., Ltd.) on the hole transporting layer to a thickness of 30 nm at a degree of vacuum of $1.0 \times 10^{-3}$ Pa or less and a deposition rate of 0.3 nm/second.

Following this, an electron transporting layer was formed from tris(8-quinolinolato)aluminum on the luminescent layer to a thickness of 20 nm at a degree of vacuum of $1.0 \times 10^{-3}$ Pa or less and a deposition rate of 0.3 nm/second.

Then, an electron injecting layer was formed from lithium fluoride on the electron transporting layer to a thickness of 0.1 nm at a degree of vacuum of $1.0 \times 10^{-3}$ Pa or less and a deposition rate of 0.05 nm/second.

Finally, aluminum was deposited as cathode to a thickness of 100 nm at a degree of vacuum of $1.0 \times 10^{-3}$ Pa or less and a deposition rate of 1.0 nm/second.

The organic EL device thus prepared was driven continuously under application of direct current in a dry atmosphere at a constant current density of 10 mA/$cm^2$. Emission of blue light with a voltage of 5.5 V and a luminance of 360 cd/$m^2$ was confirmed initially and it took 200 hours for the luminance to attenuate 10%.

Examples 7-10

Organic EL devices were prepared as in Example 6 except using each of Samples 2-5 in place of Sample 1 and the time for 10% attenuation of the luminance was measured.

Comparative Examples 3-4

Organic EL devices were prepared as in Example 6 except using each of Samples 6-7 in place of Sample 1 and the time for 10% attenuation of the luminance was measured.

The results are summarized in Table 3.

Table 3

| | Sample | 10% attenuation time (hr) | Relative ratio |
|---|---|---|---|
| Example 6 | 1 | 200 | 4.0 |

Table 3 (continued)

| | Sample | 10% attenuation time (hr) | Relative ratio |
|---|---|---|---|
| Example 7 | 2 | 200 | 4.0 |
| Example 8 | 3 | 120 | 2.4 |
| Example 9 | 4 | 80 | 1.6 |
| Example 10 | 5 | 50 | 1.0 |
| Comp. ex. 3 | 6 | 50 | 1.0 |
| Comp. ex. 4 | 7 | 50 | 1.0 |

It is apparent from Table 3 that the content of the impurity compound (B) and the attenuation of emitted blue light are closely related to each other and the impurity compound (A) does not exert an appreciable influence and that the attenuation of emitted blue light declines markedly with a decreasing content of compound (B) in the range below 2 wt%. Moreover, the content of compound (B) should necessarily be reduced to 2 wt% or less in order that the time for 10% attenuation of the luminance of blue light may exceed 50 hours.

Example 11

TPD was used as tertiary aryl amine. Compound (A) in this case is TPD less one N,N-phenyltolylamino group and compound (B) is TPD plus one N,N-phenyltolylamino group. As in Example 1, an organic EL device was prepared using TPD containing 0.4% of compound (A) and 0.3% of compound (B) as hole transporting material and the device was driven continuously in a dry atmosphere at a constant current density of 10 $mA/cm^2$. Emission of green light with a voltage of 5.2 V and a luminance of 340 $cd/m^2$ was confirmed initially and it took 8 hours for the luminance to attenuate 10%.

Comparative Example 5

An organic EL device was prepared as in Example 11 except using TPD containing 1.2% of compound (A) and 2.7% of compound (B) as hole transporting material and the device was driven continuously in a dry atmosphere at a constant current density of 10 $mA/cm^2$. It took 3 hours for the luminance of this organic EL device to attenuate 10%.

Example 12

As in Example 6, an organic EL device was prepared using TPD containing 0.4% of compound (A) and 0.3% of compound (B) as hole transporting material and the device was driven continuously in a dry atmosphere at a constant current density of 10 $mA/cm^2$. Emission of blue light with a voltage of 5.8 V and a luminance of 350 $cd/m^2$ was confirmed initially and it took 14 hours for the luminance to attenuate 10%.

Comparative Example 6

An organic EL device was prepared as in Example 12 except using TPD containing 1.2% of compound (A) and 2.7% of compound (B) as hole transporting material and the device was driven continuously in a dry atmosphere at a constant current density of 10 $mA/cm^2$. It took 7 hours for the luminance of this organic EL device to attenuate 10%.

In Examples 1 and 6 in which the impurity compounds (A) and (B) are absent, the times for 10% attenuation of emitted green light and blue light are 105 and 200 hours respectively and this indicates that the degree of attenuation varies with the color of emitted light. In the cases where the difference in color raises a problem in the operating life of device in practical applications of organic El devices, it becomes possible to control the difference in attenuation of emitted light by color within a certain range by such means as leaving some of compound (A) or (B) intentionally or removing first and adding later.

The use of materials of this invention makes it possible to prepare organic EL devices which are less prone to deteriorate in luminance in prolonged operation and exhibit excellent durability.

## Claims

1. An organic electroluminescent material comprising a tertiary aryl amine containing 2 to 4 nitrogen atoms each forming a triarylamine,

    **characterized in that**

    the organic electroluminescent material comprises 1 wt.% or less of impurity compounds (A) possessing one less nitrogen atom forming a triarylamine group than said tertiary aryl amine compound and/or 2 wt.% or less of impurity compounds (B) possessing one more nitrogen atom forming a triarylamine group than said tertiary aryl amine compound.

2. An organic electroluminescent material as claimed in claim 1 wherein the tertiary aryl amine is selected from compounds represented by the following formulas (1)-(4) :

$$(Ar_1Ar_2\ N\text{-})_2\text{-}Ar_3 \quad (1)$$

$$(Ar_1Ar_2N\text{-}Ar_3\text{-})_3\text{-}N \quad (2)$$

$$(Ar_1Ar_2N\text{-}Ar_3\text{-})_2\text{-}N\text{-}Ar_4 \quad (3)$$

$$(Ar_1Ar_2\ N\text{-})_4\text{-}Ar_5 \quad (4)$$

    wherein $Ar_1$, $Ar_2$ and $Ar_4$ are independently monovalent aryl groups, $Ar_3$ is independently a divalent aryl group and $Ar_5$ is a tetravalent aryl group.

3. An organic electroluminescent material as claimedin claim 1 wherein the tertiary aryl amine is a compound represented by the following formula (5):

$$A_1\text{-}G\text{-}A_2 \quad (5)$$

    wherein $A_1$ and $A_2$ are independently diarylamino groups and G is a divalent aryl group.

4. An organic electroluminescent material as claimed in claim 1 wherein the tertiary aryl amine is N,N'-di(naphthalen-1-yl)-N,N'-diphenylbenzidine.

5. An organic electroluminescent elemental device comprising an organic electroluminescent material as claimed in any one of claims 1 to 4.

6. An organic electroluminescent elemental device as claimed in claim 5 wherein said material is incorporated in the hole transporting layer or luminescent layer of the device.

7. An organic electroluminescent elemental device as claimed in claim 6 wherein the operating time in which the initial luminance attenuates 10% exceeds 100 hours in the life test.

8. A process for preparing an organic electroluminescent material as claimed in any of claims 1-4 which comprises purifying by sublimation or distillation the tertiary aryl amine obtained by the reaction of a haloaryl compound containing one or more halogen atoms in the aromatic ring with an aryl amine in the presence of a catalyst until the tertiary aryl amine contains 1 wt% or less of compounds possessing one less nitrogen atom forming a triarylamino group than said tertiary aryl amine compound or 2 wt% or less of compounds possessing one more nitrogen atom forming a diarylamino group than said tertiary aryl amino compound.

FIG. 1

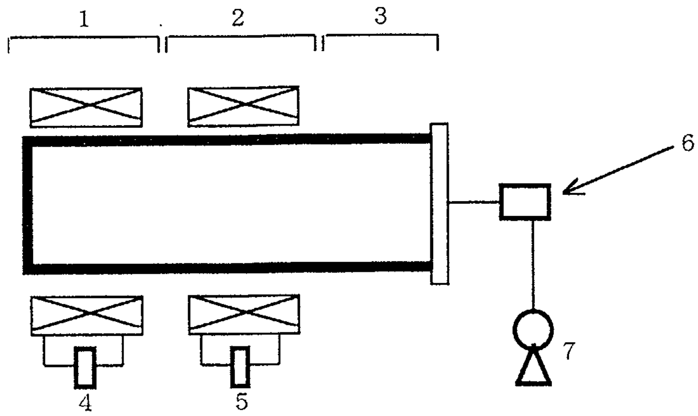


FIG. 2